# EUROPEAN PATENT SPECIFICATION

(11) **EP 2 484 817 B1**
(45) Date of publication and mention of the grant of the patent: **02.10.2019**
(21) Application number: 10820226.8
(22) Date of filing: 13.07.2010
(51) Int. Cl.: C30B 29/38, C23C 16/34, H01L 21/205, H01L 33/32, C30B 33/00, H01L 33/16, H01L 33/46

(54) **METHOD FOR PRESERVING A GALLIUM NITRIDE SUBSTRATE**
VERFAHREN ZUR KONSERVIERUNG EINES GALLIUMNITRIDSUBSTRATS
PROCÉDÉ DE PRÉSERVATION D'UN SUBSTRAT DE NITRURE DE GALLIUM

(30) Priority: 30.09.2009 JP 2009227437
(43) Date of publication of application: 08.08.2012
(73) Proprietor: Sumitomo Electric Industries, Ltd., Chuo-ku Osaka-shi Osaka 541-0041 (JP)
(72) Inventor: NAKAHATA, Seiji, Itami-shi Hyogo 664-0016 (JP)
(74) Representative: Grünecker Patent- und Rechtsanwälte PartG mbB
(86) International application number: PCT/JP2010/061811
(87) International publication number: WO 2011/040106

(56) References cited:
- EP-A1- 1 995 786
- EP-A2- 1 868 252
- CN-A- 1 464 543
- JP-A- 2 204 400
- JP-A- 2005 029 233
- JP-A- 2006 315 947
- JP-A- 2007 335 583
- JP-A- 2008 285 364
- ENYA Y. ET AL: '531nm green lasing of InGaN based laser diodes on semi-polar {20-21} free- standing GaN substrates' APPL. PHYS. EXP. vol. 2, 17 July 2009, pages 082101-1 - 082101-3, XP001552526

## Description

### Technical Field

The present invention relates to a methods of storing GaN substrates whose principal-face plane orientation is other than (0001̅) or (0001̅).

### Background Art

Of late, in order to sustain, at a high level, photoemission efficiency in which blue-shift in the emission from LEDs (light-emitting diodes), LDs (laser diodes) and like semiconductor devices has been reduced, semipolar or nonpolar GaN substrates, whose principal-face plane orientation is other than (0001) or (0001̅), are being employed as the substrates for these semiconductor devices. "Nonpolar GaN substrates" signify GaN substrates having nonpolar faces as the principal faces, and specifically mean GaN substrates having principal faces of plane orientation inclined 90° (i.e., perpendicular) to the plane-either the (0001) plane or the (0001̅) plane-that is the polar plane. "Semipolar GaN substrates" mean, specifically, GaN substrates having principal faces of plane orientation inclined greater than 0° and less than 90°to the plane-either the (0001) plane or the (0001̅) plane-that is the polar plane.

Therein, with the process whereby the GaN substrates are manufactured ordinarily being a process separate from the process whereby the manufactured GaN substrates are used to produce semiconductor devices, the manufactured GaN substrates are stored for a fixed time period, and thereafter used for producing the semiconductor devices.

Therefore, in Japanese Unexamined Patent App. Pub. No. 2000-355392 (Patent Literature 1) for example, methods for housing and storing manufactured GaN substrates have been proposed. Owing to the fact that the housing and storing is done under an atmosphere within clean air, conventional methods of storing GaN substrates, however, lead to the front side of the GaN substrates oxidizing, due to long-term storage, and have been prohibitive of producing semiconductor devices of favorable properties.

Therefore, in Japanese Unexamined Patent App. Pub. No. 2007-335583 (Patent Literature 2) for example, a method of keeping a GaN substrate having as its principal faces planes that are polar planes-either the (0001) plane or the (0001̅) plane-within an atmosphere in which the oxygen concentration and water-vapor concentration in air are controlled has been proposed. But if the aforementioned semipolar or nonpolar GaN substrates are stored by the method set forth in Japanese Unexamined Patent App. Pub. No. 2007-335583 (Patent Literature 2), considerable irregularities have arisen in the properties of semiconductor devices manufactured using the post-storage semipolar or nonpolar GaN substrates.

Document EP 1 995 786 A1 relates to GaN substrate (30) whose growth plane (30a) is oriented off-axis with respect to either the m-plane or the a -plane. That is, in the GaN substrate (30), the growth plane (30a) is either an m -plane or an a -plane that has been misoriented. Inasmuch as the m-plane and the a -plane are nonpolar, utilizing the GaN substrate (30) to fabricate a semiconductor light-emitting device (60) averts the influence of piezoelectric fields, making it possible to realize superior emission efficiency. Imparting to the growth plane the off-axis angle in terms of either the m -plane or the a -plane realizes high-quality morphology in crystal grown on the substrate. Utilizing the GaN substrate to fabricate semiconductor light-emitting devices enables as a result the realization of further improved emission efficiency.

Document EP 1 868 252 A1 relates to a method of storing GaN substrates from which semiconductor devices of favorable properties can be manufactured, the stored substrates, and semiconductor devices and methods of manufacturing the semiconductor devices. In the GaN substrate storing method, a GaN substrate (1) is stored in an atmosphere having an oxygen concentration of 18 vol. % or less, and/or a water-vapor concentration of 12 g/m 3 or less. Surface roughness Ra of a first principal face on, and roughness Ra of a second principal face on, the GaN substrate stored by the storing method are brought to no more than 20 nm and to no more than 20 µm, respectively. In addition, the GaN substrates are rendered such that the principal faces form an off-axis angle with the (0001) plane of from 0.05° to 2° in the <1100> direction, and from 0° to 1 ° in the <1120> direction.

### Citation List

### Patent Literature

PTL 1: Japanese Unexamined Pat. App. Pub. No. 2000-355392
PTL 2: Japanese Unexamined Pat. App. Pub. No. 2007-335583

### Summary of Invention

### Technical Problem

An object of the present invention, to solve the problems discussed above, is to make available: a method of storing GaN substrates whose principal-face plane orientation is other than (0001) or (0001̅), with which semiconductor devices of favorable properties can be manufactured.

### Solution to Problem

The object of the present invention, in accordance with a certain aspect thereof, is solved by a GaN substrate storage method according to claim 1.

In a GaN substrate storage method involving the present invention, the oxygen concentration can be made 10 vol. % or less, and the water-vapor concentration 15 g/m3 or less. Furthermore, the oxygen concentration can be brought to 6 vol. % or less, and the water-vapor concentration to 5 g/m3 or less. Likewise, the atmosphere under which the GaN substrates are stored can be formed from a gaseous mixture containing an inert gas, gaseous oxygen, and water vapor, with the oxygen concentration being made not less than 0.05 vol. % and the water-vapor concentration not less than 0.1 g/m3.

Additionally, in a GaN substrate stored by a storing method involving the present invention, the average roughness Ra of a first principal face thereof can be made 20 nm or less, while the average roughness Ra of a second principal face thereof can be made 20 µm or less. Furthermore, the average roughness Ra of the first principal face can be brought to 5 nm or less, and the average roughness Ra of the second principal face to 10 µm or less.

### Advantageous Effects of Invention

The present invention affords: a method of storing GaN substrates whose principal-face plane orientation is other than (0001) or (000-1), with which semiconductor devices of favorable properties can be manufactured; such GaN substrates stored by the storing method; as defined by claim 1.

### Brief Description of Drawings

Fig. 1 is a schematic diagram representing one mode of embodying a GaN substrate storage method involving the present invention.
Fig. 2 is a schematic diagram representing one mode of embodying a GaN substrate involving the present invention.
Fig. 3 is a simplified diagram specifically representing one mode of embodying a GaN substrate involving the present invention. Therein, (A) depicts a simplified plan view of the GaN substrate, (B) depicts a simplified sectional view along IIIB - IIIB in (A), and (C) depicts a simplified sectional view along IIIC - IIIC in (A).
Fig. 4 is a simplified diagram specifically representing one mode of embodying a semiconductor device including a GaN substrate involving the present invention. Therein, (A) depicts a simplified plan view of the GaN substrate, and (B) depicts a simplified sectional view along IVB - IVB in (A).
Fig. 5 is a simplified sectional diagram representing one mode of embodying a semiconductor device involving the present invention.
Fig. 6 is a simplified diagram representing a method of manufacturing a GaN substrate involving the present invention. Therein, (A) represents an operation of cutting a plurality of GaN parent-crystal pieces from a GaN parent crystal, (B) represents an operation of arranging a plurality of GaN parent-crystal pieces adjoining each other sideways, (C) represents an operation of growing GaN crystal onto the plurality of parent-crystal GaN pieces and cutting out a GaN substrate, and (D) represents a further operation of growing GaN crystal and cutting out a GaN substrate.

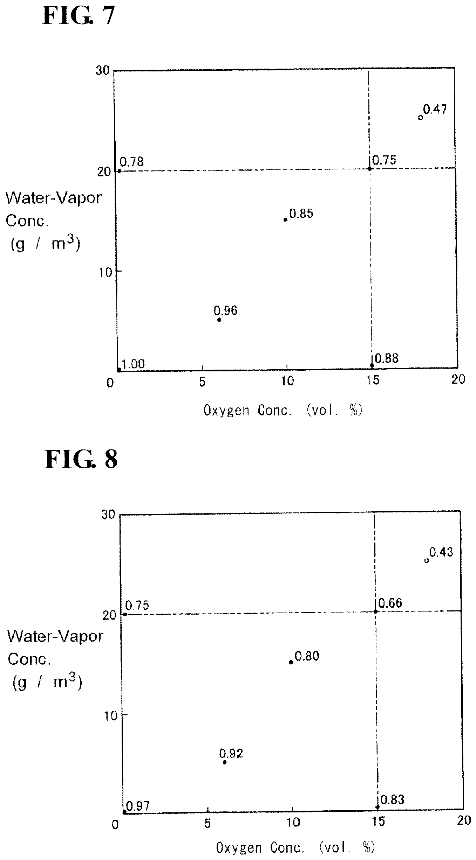

Fig. 7 is a graph charting one example of the relationship between semiconductor device properties, and oxygen concentration and water-vapor concentration in an atmosphere for storing GaN substrates.
Fig. 8 is a graph charting another example of the relationship between semiconductor device properties, and oxygen concentration and water-vapor concentration in an atmosphere for storing GaN substrates.

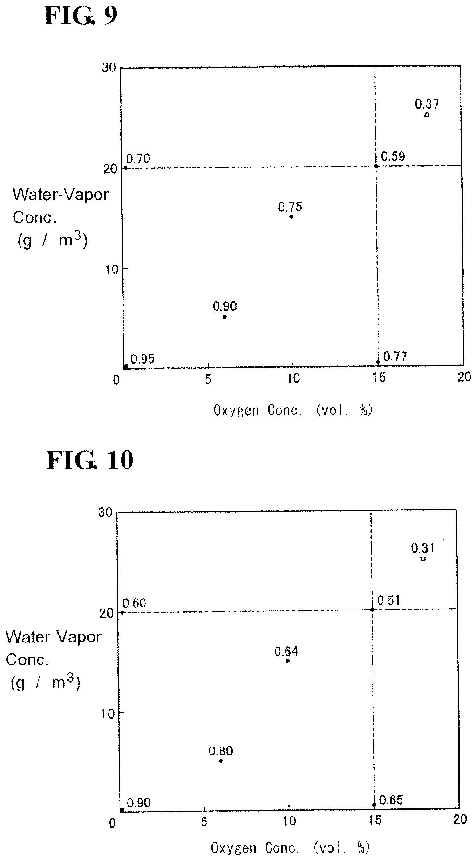

Fig. 9 is a graph charting a further example of the relationship between semiconductor device properties, and oxygen concentration and water-vapor concentration in an atmosphere for storing GaN substrates.
Fig. 10 is a graph charting a still further example of the relationship between semiconductor device properties, and oxygen concentration and water-vapor concentration in an atmosphere for storing GaN substrates.

### Description of Embodiments

In crystallography, in order to express the plane orientation of crystalline planes, notation (Miller notation) such as (*hkl*) or (*hkil*) is used. The plane orientation of crystalline planes in Group III-nitride crystal and other hexagonal-system crystal constituting GaN parent crystal, GaN parent-crystal pieces, GaN crystal, GaN substrates, etc., is expressed by (*hkil*)*.* Herein, *h, k, i* and *l* are integers referred to as Miller indices, and have the relationship *i* = *-*(*h* + *k*). A plane of (*hkil*) plane orientation is called an (*hkil*) plane. Likewise, the direction perpendicular to the (*hkil*) plane (the direction normal to the (*hkil*) plane) is called the [*hkil*] direction. And {*hkil*} signifies a family of plane orientations that includes (*hkil*) and the individual plane orientations that are its crystallographic equivalent, while *<hkil>* signifies a family of directions that includes [*hkl*] and the individual directions that are its crystallographic equivalent.

### Embodying Mode 1

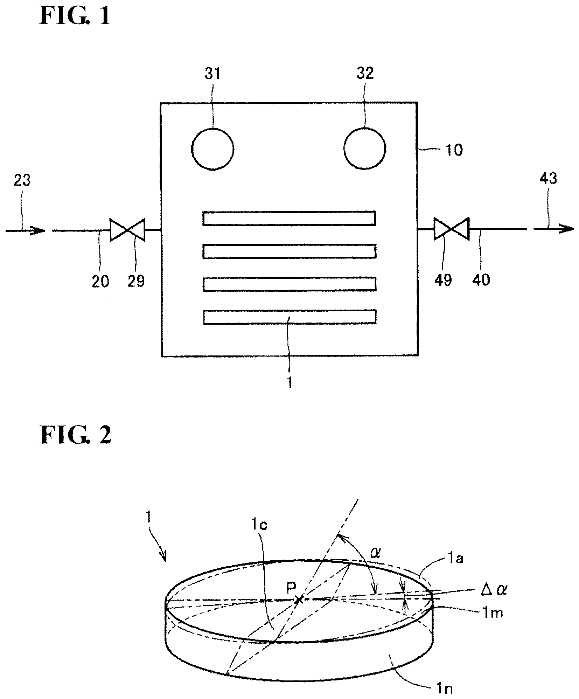

Reference is made to Fig. 1 and Fig. 2: One mode of embodying a GaN substrate storage method within an atmosphere in which the oxygen concentration is not greater than 15 vol. % and the water-vapor concentration is not greater than 20 g/m³, a GaN substrate 1 having a planar first principal face 1*m*, and whose plane orientation in an arbitrary point *P* along the first principal face 1*m* and separated 3 mm or more from the outer edge thereof has an off-inclination angle (in Fig. 2, off-inclination angle *Δα*) of -10° or more, 10° or less (not part of the invention) with respect to the plane orientation of an arbitrarily designated crystalline plane 1*a* that is inclined 50° or more, 90° or less (in Fig. 2, inclination angle *α*) with respect to a plane, being either the (0001) plane or the (0001) plane, through the arbitrary point *P.*

Storing the aforedescribed GaN substrates under the atmosphere in which the oxygen concentration is not greater than 15 vol. % and the water-vapor concentration is not greater than 20 g/m³ makes it possible to keep oxidation of the GaN substrate surfaces to a minimum, enabling the manufacture of semiconductor devices of favorable properties. From such perspectives, the oxygen concentration is preferably not greater than 10 vol. % and the water-vapor concentration not greater than 15 g/m³, and more preferably, the oxygen concentration is not greater than 6 vol. % and the water-vapor concentration is not greater than 5 g/m³. On the other hand, from the perspective of reducing the cost of creating the atmosphere for storing the GaN substrates, preferably the oxygen concentration is 0.05 vol. % or more and the water-vapor concentration is 0.1 g/m³ or more.

Herein, the technique whereby in the atmosphere for storing the above-described GaN substrates the oxygen concentration is made not greater than 15 vol. % and the water-vapor concentration is made not greater than 20 g/m³ is not particularly limited, wherein a storing device 10 as represented in Fig. 1 may for example be employed. Therein, the storing device 10 in Fig. 1 is equipped with a gas introduction line 20, a gas introduction valve 29, a gas exhaust line 40, and a gas exhaust valve 49.

As a way to have the oxygen concentration be no more than 15 vol. % and the water-vapor concentration be no more than 20 g / m³ in an atmosphere for storing the aforedescribed GaN substrates, one technique (referred to as "Technique I"-likewise below) is, with GaN substrates 1 placed inside the storing device 10, to introduce low gas 23 of oxygen concentration not greater than 15 vol. % and water-vapor concentration not greater than 20 g/m³ into the storing device 10, exhausting gas 43 of oxygen concentration higher than 15 vol. % as well as water-vapor concentration higher than 20 g/m³. Another technique (referred to as "Technique II"-likewise below) is to place, together with the GaN substrates 1, an oxygen scavenger 31 and a dehydrating agent 32 a inside the storing device 10. Moreover, Technique I and Technique II can be employed in tandem.

Herein, the gas whose oxygen concentration and water-vapor concentration are, respectively, not greater than 15 vol. % and not greater than 20 g/m³ is not particularly limited, but from the perspective of not causing chemical reactions with the surfaces of the GaN substrates, other than an inert gas such as gaseous nitrogen or gaseous argon, gaseous mixtures containing these inert gases and a predetermined quantity or less of gaseous oxygen and water vapor are preferable. In particular, from a low-cost perspective, a just-mentioned gaseous mixture of an inert gas and gaseous oxygen and water vapor, being a gaseous mixture whose oxygen concentration and water-vapor concentration are, respectively, not greater than 15 vol. % and not greater than 20 g/m³, is preferable. Also, the oxygen scavenger is not particularly limited, but from the perspective of not causing chemical reactions with the GaN substrate surfaces, active iron oxide, activated carbon, or the like is preferable. Likewise, while the dehydrating agent is not particularly limited, from the perspective of not causing chemical reactions with the GaN substrate surfaces, silica gel, activated carbon, or the like is preferable.

Furthermore, the measuring of the oxygen concentration is not particularly limited, but can be carried out by means of a galvanic oxygen analyzer. Likewise, the measuring of the water-vapor concentration is not particularly limited, but may be carried out by means of a dielectric aquameter or a Karl Fischer moisture analyzer.

The temperature of the atmosphere for storing the GaN substrates is also not particularly limited, but from the perspective of not causing chemical reactions with the surface of the GaN substrates, it is preferably not greater than 60°C, with not greater than 40°C being more preferable. In addition, from the perspective of preventing condensation, 5°C or greater is preferable, with 10°C or greater being more preferable.

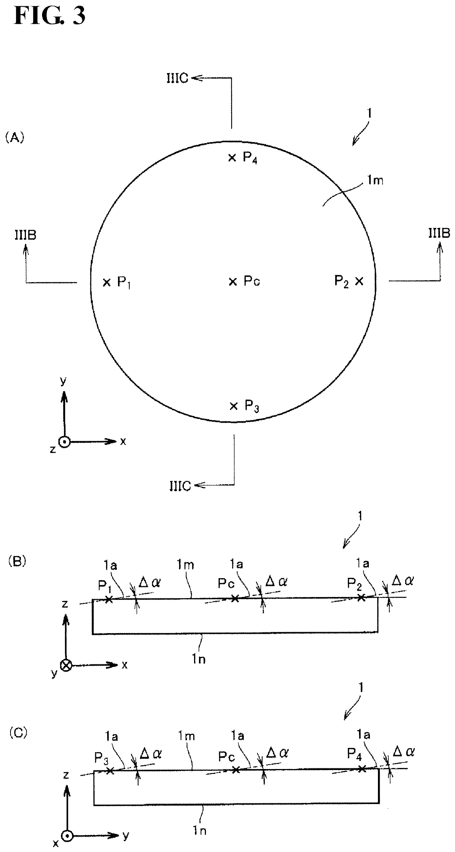

A GaN substrate stored in a storage method of the present embodying mode has, referring to Fig. 2 and Fig. 3, a planar first principal face 1*m*, and its plane orientation in an arbitrary point *P* along the first principal face 1*m* and separated 3 mm or more from the outer edge thereof (e.g., Point *P_{c},* Point *P₁*, Point *P₂,* Point *P₃,* Point *P₄*, etc.) has an off-inclination angle *Δα* of - 10° or more, 10° or less with respect to the plane orientation of an arbitrarily designated crystalline plane 1*a* that is inclined 50° or more, 90° or less (in Fig. 2, inclination angle *α*) with respect to a plane 1*c*, being either the (0001) plane or the (0001) plane, through the arbitrary point *P.*

With a GaN substrate in the present embodying mode, because (i) it has a planar first principal face 1*m*, and (ii) its plane orientation in an arbitrary point along the first principal face 1*m* and separated 3 mm or more from the outer edge thereof has an off-inclination angle *Δα* of - 10° or more, 10° or less with respect to the plane orientation of an arbitrarily designated crystalline plane 1*a* that is inclined 50° or more, 90° or less with respect to a plane 1*c*, being either the (0001̅) plane or the (0001̅) plane, through the arbitrary point, by growing an at least single-lamina semiconductor layer onto the first principal face 1*m,* a semiconductor device of minimal blue shift in photoemission and high emission efficiency is obtained. In particular, because the off-inclination angle *Δα* of its plane orientation in an arbitrary point along the first principal face 1*m* and separated 3 mm or more from the outer edge thereof is small, in the aforedescribed storing of the GaN substrate, inside the storing device reacting of oxygen and water vapor with the surfaces of the GaN substrate is controlled to a minimum, and the amount of oxygen and water-vapor adsorption onto the GaN substrate surfaces is reduced, whereby high-emission-efficiency semiconductor devices is obtained.

Furthermore, as for GaN substrates of the present embodying mode, from the perspectives of keeping reaction of oxygen and water vapor inside the storing device with the GaN substrate surfaces under control, and of reducing the amount of oxygen and water-vapor adsorption into the GaN substrate surfaces, preferably the average roughness *Ra* of the first principal face 1*m* is not greater than 20 nm, and the average roughness *Ra* of the second principal face 1*n* is not greater than 20 *µ*m. From such perspectives, it is more preferable that the average roughness *Ra* of the first principal face 1*m* be 5 nm or less, and that the average roughness *Ra* of the second principal face 1*n* be 10 *µ*m or less. Although the relationship between the average roughness *Ra* of first principal face 1*m* and second principal face 1*n* of the GaN substrate 1 and the reactivity and adsorptivity of oxygen and water vapor with these principal faces 1*m* and 1*n* of the GaN substrate 1 is not clear, the reduction in surface area from lessening the average roughness *Ra* is believed to be relevant as one causative factor. Herein, the "first principal face 1*m*" means the principal face on which semiconductor layers are grown, while the "second principal face 1*n*" means the principal face on the side opposite from said first principal face 1*m*. Furthermore, "average roughness *Ra* of a surface" means arithmetic mean roughness Ra stipulated in JIS B 0601:2001, and refers to a value in which a predetermined reference surface area is chosen from the roughness topography along its average plane, and the absolute values of the deviation from the average plane of the chosen portion to the profiling topography are summed and the total is averaged in the reference surface area. Such surface average roughness *Ra* can be measured employing a non-contact interferometer, 3D-SEM (three-dimensional scanning electron micrometer), AFM (atomic-force microscope), or the like.

With further regard to a GaN substrate of the present embodying mode, referring to Fig. 2, the plane orientation of the foregoing arbitrarily designated crystalline plane 1*a* preferably is {20 2̅ 1}. With a GaN substrate 1 in which the plane orientation in an arbitrary point *P* along the first principal face 1*m* of the GaN substrate 1 and separated 3 mm or more from the outer edge thereof has an off-inclination angle *Δα* of - 10° or more, 10° or less with respect to {20 2̅ 1}, because semiconductor layers of high crystalline quality can be grown stably onto its first principal face 1*m*, a semiconductor device of minimal blue shift in photoemission and high emission efficiency is obtained.

Further in respect of a GaN substrate of the present embodying mode, referring to Fig. 2 and Fig. 3, from the perspectives of keeping oxygen and water vapor inside the storing device from reacting with the GaN substrate surfaces, and of reducing the amount of oxygen and water-vapor adsorption into the GaN substrate surfaces, preferably the plane orientation in an arbitrary point *P* along the first principal face 1*m* and separated 3 mm or more from the outer edge thereof (e.g., Point *P_{c},* Point *P₁*, Point *P₂,* Point *P₃* and Point *P₄*) has an off-inclination angle *Δα* of - 10° or more, 10° or less in a <1 2̅ 10> direction, and of -10° or more, 10° or less (not part of the invention) in a direction perpendicular to a <20 2 1> direction and to a <1 2 10> direction, has an off-inclination angle *Δα* of -3° or more, 3° or less (invention) in a <1 2 10> direction with respect to {20 2 1}, and of -3° or more, 3° or less in a direction perpendicular to a <20 2̅ 1> direction and to a <1 2̅ 10> direction, and still more preferably has an off-inclination angle of -0.5° or more, 0.5° or less in a <1 2̅ 10> direction with respect to {20 2̅ 1}, and of -0.5° or more, 0.5° or less in a direction perpendicular to a <20 2̅ 1> direction and to a <1 2̅ 10> direction.

While the relationship between the off-inclination angle *Δα* between {20 2̅ 1} and the plane orientation in an arbitrary point along the first principal face 1*m* of the GaN substrate 1 and separated 3 mm or more from the outer edge thereof, and the reactivity and adsorptivity of oxygen and water vapor with respect to the first principal face 1*m* of the GaN substrate 1 is not clear, what is believed to be relevant as one causative factor is that having a predetermined off-inclination angle *Δα* varies the number of sites along the first principal face 1*m* of the GaN substrate 1 where oxygen and water vapor may bond. The off-inclination angle *Δα* between {20 2̅ 1} and the plane orientation in an arbitrary point along the first principal face of the GaN substrate and separated 3 mm or more from the outer edge thereof can be measured by an XRD (x-ray diffraction) technique.

Here, in the present embodying mode, referring to Fig. 1, with the atmosphere inside the storing device 10 in which the GaN substrates 1 are housed having been rendered storing conditions in the invention of the present application (for example, that the oxygen concentration be not greater than 15 vol. % and the water-vapor concentration be not greater than 20 g/m³), the GaN substrates 1 can be stored by sealing the GaN substrates 1 into a (not-illustrated) storage container (e.g., an aluminum pouch or the like) that shuts out oxygen and water vapor. Further, GaN substrates hermetically sealed in a storage container can be taken out of the storing device 10 and stored.

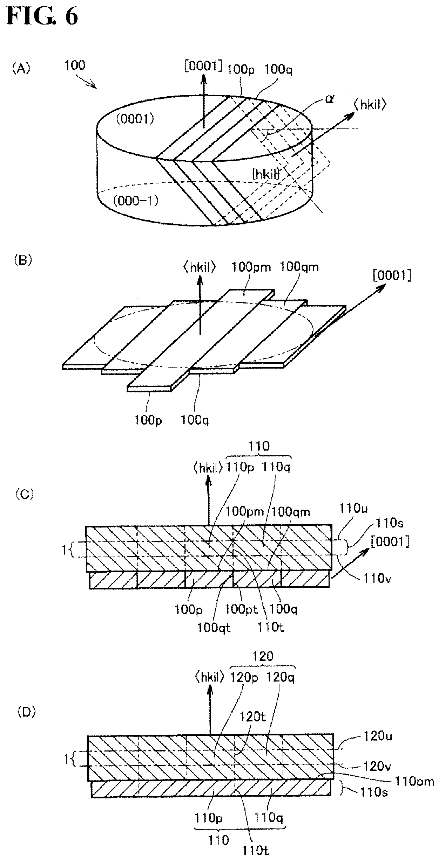

With reference to Fig. 6, in a GaN substrate manufacturing method of the present embodying mode, while not particularly limited, included are: a step (Fig. 6(A)) of cutting from a GaN parent crystal 100 a plurality of GaN parent-crystal pieces 100*p* and 100*q* having principal faces 100*pm* and 100*qm* whose off-inclination angle is -5° or more, 5° or less with respect to a plane orientation {*hkil*} having an inclination angle *α* of 50° or more, 90° or less with respect to a plane, being either the (0001) plane or the (0001̅) plane, of the GaN parent crystal; a step (Fig. 6(B)) of arranging the GaN parent-crystal pieces 100*p* and 100*q* adjoining each other sideways in such a way that the principal faces 100*pm* and 100*qm* of the GaN parent-crystal pieces 100*p* and 100*q* parallel each other, and the [0001] directions of the GaN parent-crystal pieces 100*p* and 100*q* are identical; a step (Fig. 6(C)) of growing GaN crystal 110 onto the principal faces 100*pm* and 100*qm* of the GaN parent-crystal pieces 100*p* and 100*q*; and a step (Fig. 6(C)) of cutting out a GaN substrate 1 of Embodying Mode 1 from the grown GaN crystal 110.

In the above-described steps, GaN crystal 110 in which the off-angle between the plane orientation of the principal face of a sectional region 110*p* of the GaN crystal 110 that grows onto the GaN parent-crystal piece 100*p*, and the plane orientation of the principal face of a sectional region 110*q* of the GaN crystal 110 that grows onto the GaN parent-crystal piece 100*q* is -10° or more, 10° or less can be grown. Herein, the sectional regions 110*p* and 110*q* of the GaN crystal 110 are regions of the GaN crystal partitioned by planes (referred to as extension planes 110*t* hereinafter) extending, into the GaN crystal 110 interior, the lateral sides 100*pt* and 100*qt* where the GaN parent-crystal pieces 100*p* and 100*q* adjoin each other.

By cutting the thus-obtained GaN crystal 110 in planes 110*u* and 110*v* parallel to the plane of the {*hkil*} plane orientation mentioned earlier, a GaN substrate 1 having a planar first principal face 1*m*, and whose plane orientation in an arbitrary point along the first principal face 1*m* and separated 3 mm or more from the outer edge thereof has an off-inclination angle of -10° or more, 10° or less with respect to the plane orientation of an arbitrarily designated crystalline plane that is inclined 50° or more, 90° or less with respect to a plane, being either the (0001) plane or the (0001) plane, through the arbitrary point is obtained.

Therein, from the perspective of making the off-inclination angle through the aforementioned arbitrary point in the GaN substrate 1 small, the off-inclination angle with respect to the aforementioned plane orientation {*hkil*} of the principal faces *100pm* and 100*qm* of the plurality of GaN parent-crystal pieces 100*p* and 100*q* preferably is -10° or more, 10° or less, more preferably -3° or more, 3° or less, still more preferably -0.5° or more, 0.5° or less. And from the perspective of growing GaN crystal of high crystalline quality, the average roughness *Ra* of the principal faces 100*pm* and 100*qm* and lateral sides 100*pt* and 100*qt* of the GaN parent-crystal pieces 100*p* and 100*q* preferably is not grater than 50 nm, more preferably not greater than 5 nm.

And the method for growing the GaN crystal 110, while not particularly limited preferably is, from the perspective of growing GaN crystal of high crystalline quality, a vapor-phase method such as an HVPE (hydride vapor-phase epitaxy) technique, an MOCVD (metalorganic chemical vapor deposition) technique or an MBE (molecular-beam epitaxy) technique, or a liquid-phase method such as flux growth. From the perspective of the crystal growth rate being considerable, an HVPE technique is further preferable. If the GaN crystal 110 is grown by an HVPE technique, from the perspective of making the off-inclination angle through the aforementioned arbitrary point in the GaN substrate 1 small, the crystal-growth conditions preferably are that the crystal-growth temperature is 950°C or more, 1200°C or less, and the crystal-growth rate is 30 µm/hr or more, 300 µm/hr or less.

In a method of manufacturing a GaN substrate of the present embodying mode, a step (Fig. 6(D)) of utilizing, as a GaN starting substrate 110*s*, a GaN substrate 1 cut out from the grown GaN crystal 110 in planes 110*u* and 110*v* parallel to a plane of {*hkil*} plane orientation, and growing further GaN crystal 120 onto the principal face 110*pm* of such GaN starting substrate 110*s*, and a step (Fig. 6(D)) of cutting a GaN substrate 1 of Embodying Mode 1 out from the grown further GaN crystal 120 can further be included.

By the above-described steps, further GaN crystal 120 in which the off-angle between the plane orientation of the principal face of a sectional region 120*p* of the further GaN crystal 120 that grows onto the sectional region 110*p* of the GaN starting substrate 110s, and the plane orientation of the principal face of a sectional region 120*q* of the further GaN crystal 120 that grows onto the sectional region 110*q* of the GaN starting substrate 110s is -10° or more, 10° or less can be grown. Herein, the sectional regions 120*p* and 120*q* of the further GaN crystal 120 are regions of the further GaN crystal partitioned by planes (referred to as extension planes 120*t* hereinafter) extending, into the further GaN crystal 120 interior, the extension planes 110*t* of the GaN starting substrate 110*s*.

By cutting the thus-obtained further GaN crystal 120 in planes 120*u* and 120*v* parallel to the plane of {*hkil*} plane orientation, a GaN substrate 1 having a planar first principal face 1*m*, and whose plane orientation in an arbitrary point along the first principal face 1*m* and separated 3 mm or more from the outer edge thereof has an off-inclination angle of -10° or more, 10° or less (not part of the invention) with respect to the plane orientation of an arbitrarily designated crystalline plane that is inclined 50° or more, 90° or less with respect to a plane, being either the (0001) plane or the (0001̅) plane, through the arbitrary point is obtained.

The method for growing the further GaN crystal 120, while not particularly limited preferably is, from the perspective of growing GaN crystal of high crystalline quality, a vapor-phase method such as an HVPE technique, an MOCVD technique or an MBE technique, or a liquid-phase method such as flux growth. From the perspective of the crystal growth rate being considerable, an HVPE technique is further preferable. If the further GaN crystal 120 is grown by an HVPE technique, from the perspective of making the off-inclination angle through the aforementioned arbitrary point in the GaN substrate 1 small, the crystal-growth conditions preferably are that the crystal-growth temperature is 950°C or more, 1200°C or less, and the crystal-growth rate is 30 µm/hr or more, 300 µm/ hr or less.

### Embodying Mode 2

Reference is made to Fig. 1 through Fig. 3: One mode of embodying a GaN substrate involving the present invention is a GaN substrate 1, stored within an atmosphere in which the oxygen concentration is not greater than 15 vol. % and the water-vapor concentration is not greater than 20 g / m³, having a planar first principal face 1*m*, and whose plane orientation in an arbitrary point along the first principal face 1*m* and separated 3 mm or more from the outer edge thereof has an off-inclination angle *Δα* of -10° or more, 10° or (not part of the invention) with respect to the plane orientation of an arbitrarily designated crystalline plane 1*a* that is inclined 50° or more, 90° or less with respect to a plane 1*c*, being either the (0001) plane or the (0001) plane, through the arbitrary point. With a GaN substrate of the present embodying mode, stored by a method of Embodying Mode 1, because surface oxidation is kept to a minimum, by growing an at least single-lamina semiconductor layer onto the first principal face 1*m*, a semiconductor device of superior properties is obtained.

### Embodying Mode 3

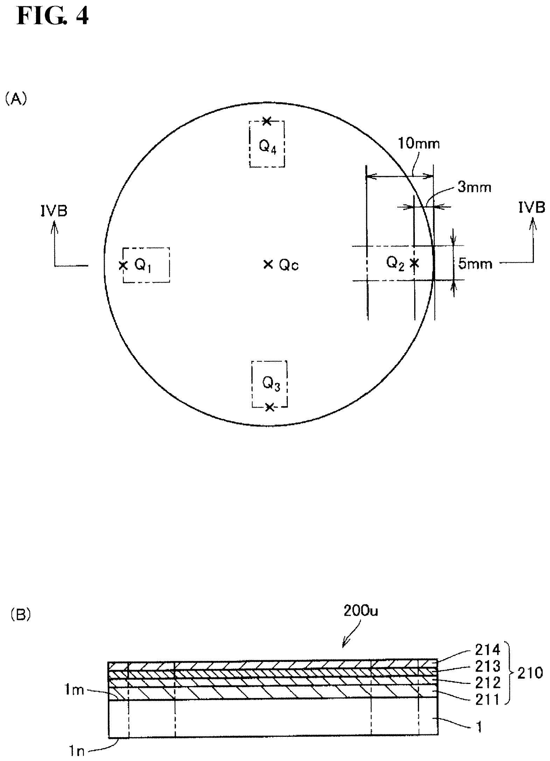

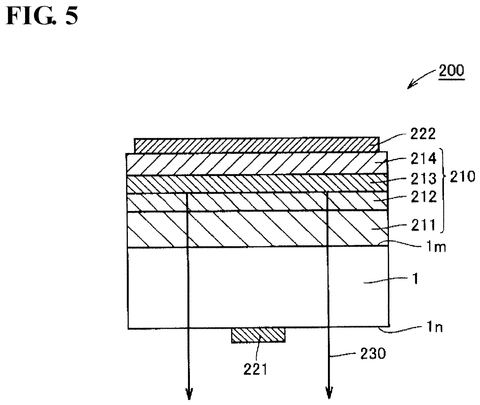

Reference is made to Fig. 4 and Fig. 5: One mode of embodying a semiconductor device includes a GaN substrate 1 of Embodying Mode 2, stored by a method of Embodying Mode 1, and an at least single-lamina semiconductor layer 210 formed onto the first principal face 1*m* of the GaN substrate 1. With a semiconductor device of the present embodying mode, because a semiconductor layer 210 of high crystalline quality is formed onto the first principal face 1*m* of a GaN substrate 1 in which oxidation of its surfaces has been kept to a minimum, a semiconductor device of superior properties is obtained.

There are no particular limitations on the semiconductor layer 210 formed onto the GaN substrate 1, but in view of the crystal lattices being highly coordinate, a Group III nitride semiconductor layer such as an Al*ₓ*Ga*_{y}*In_{1-*x*-*y*}N (0 ≤ *x*, 0 ≤ *y*, *x* + *y* ≤ 1) layer is preferable. Likewise, while there are no particular limitations on the semiconductor-layer formation method, from the perspective of forming a semiconductor layer 210 of high crystalline quality onto the GaN substrate 1, it is preferable to employ an HVPE technique, an MOCVD technique or an MBE technique. From the viewpoint of allowing precise control of the thickness and chemical composition of the semiconductor layer 210 formed onto the GaN substrate 1, an MOCVD technique is further preferable.

With a semiconductor device of the present embodying mode, referring to Fig. 4 and Fig. 5, specifically an *n*-type GaN lamina 211, an In_{0.2}Ga_{0.8}N lamina 212, an Al_{0.2}Ga_{0.8}N lamina 213, and a *p*-type GaN lamina 214 are formed as the at least single-lamina semiconductor layer 210 in order onto the first principal face 1*m* of a GaN substrate 1 of Embodying Mode 2, and further, onto the second principal face 1*n* of the GaN substrate 1, an *n*-side electrode 221 is formed, and onto the principal face of the *p*-type GaN layer 214 a *p*-side electrode 222 is, wherein photoemission 230 is put out.

### Embodiment 4

Reference is made to Fig. 3 through Fig. 5: One mode of embodying a method, of manufacturing a semiconductor device includes a step of preparing a GaN substrate 1 of Embodying Mode 2, stored by a method of Embodying Mode 1, and a step of growing an at least single-lamina semiconductor layer 210 onto the first principal face 1*m* of the GaN substrate 1. By such steps a semiconductor device of superior properties is obtained.

A semiconductor-device manufacturing method of the present embodying mode, referring to Fig. 3 through Fig. 5, includes the step of preparing a GaN substrate 1 of Embodying Mode 2, stored by a method of Embodying Mode 1. Such step of preparing a GaN substrate 1 is as set forth in Embodying Mode 1 and Embodying Mode 2.

A semiconductor-device manufacturing method of the present embodying mode, referring to Fig. 4 and Fig. 5, includes the step of growing an at least single-lamina semiconductor layer 210 onto the first principal face 1*m* of the GaN substrate 1. The semiconductor layer 210 grown onto the GaN substrate 1, while not particularly limited, preferably is, in view of the crystal lattices being highly coordinate, a Group III nitride semiconductor layer such as an Al*ₓ*Ga_{y}In_{1-*x*-*y*}N (0 ≤ *x*, 0 ≤ *y, x* + *y* ≤ 1) layer. Likewise, while there are no particular limitations on the semiconductor-layer growth method, from the perspective of epitaxially growing the semiconductor layer 210 with ease onto the GaN substrate 1, it is preferable to employ an HVPE technique, an MOCVD technique or an MBE technique. From the viewpoint of allowing precise control of the thickness and chemical composition of the semiconductor layer 210 grown onto the GaN substrate 1, an MOCVD technique is further preferable.

With a semiconductor device manufacturing method of the present embodying mode, referring to Fig. 4 and Fig. 5, by for example growing, by means of an MOCVD technique, in order onto the first principal face 1*m* of the GaN substrate 1 of Embodying Mode 2, an *n*-type GaN lamina 211, an In_{0.2}Ga_{0.8}N lamina 212, an Al_{0.2}Ga_{0.8}N lamina 213, and a *p*-type GaN lamina 214, as the at least single-lamina semiconductor layer 210, a semiconductor layer wafer 200*u* is obtained. Subsequently, by forming an *n*-side electrode 221 onto the second principal face 1*n* of the GaN substrate 1 in the semiconductor layer wafer 200*u*, and forming a *p*-side electrode 222 onto the principal face of the *p*-type GaN layer 214, a semiconductor device 200 is obtained. The thus-obtained semiconductor device 200 puts out photoemission 230.

### Embodiment Examples

### Embodiment Example I

### 1. Manufacture of GaN Substrates

Reference is made to Fig. 6(A): The (0001) side and the (0001̅) side-the two principal faces-of a GaN parent crystal 100 of 50.8 mm diameter and 3mm thickness, produced by an HVPE technique, were ground and polished to an average roughness *Ra* of the two principal faces of 5 nm. Herein, the average roughness *Ra* of the surfaces was characterized employing AFM.

Subsequently, the GaN parent crystal 100 with the average roughness *Ra* of its two principal faces having been made 5 nm was sliced in a plurality of planes perpendicular to <20 2̅ 1> directions, whereby a plurality of GaN parent-crystal pieces 100*p* and 100*q*, having {20 2̅ 1} principal faces, of 3.1 mm width, 20 to 50.8 mm length, and 1 mm thickness were cut from it. Following that, the not-ground and not-polished four sides of each cut-out GaN parent-crystal piece were ground and polished to bring the average roughness *Ra* of the four sides to 5 nm. Thus, a plurality of GaN parent-crystal pieces whose {20 2̅ 1} principal-face average roughness *Ra* was 5 nm were obtained. Among these GaN parent-crystal pieces were GaN parent-crystal pieces whose principal-face plane orientation did not coincide with {20 2̅ 1}, but even with any of such GaN parent-crystal pieces the off-inclination angle of its principal-face plane orientation with respect to {20 2̅ 1} was -0.1° or more, 0.4° or less. Herein, the off-inclination angle was measured by x-ray diffractometry.

Next, referring to Fig. 6(B), these GaN parent-crystal pieces were arranged adjoining each other sideways inside the crystal-growth chamber of an HVPE apparatus, in such a way that the {20 2̅ 1} principal faces 100*pm* and 100*qm* of the plurality of GaN parent-crystal pieces 100*p* and 100*q* paralleled each other, and in such a way that the [0001] directions of the GaN parent-crystal pieces 100*p* and 100*q* were identical. In that situation, referring to Fig. 1(C), the average roughness *Ra* of the mutually adjoining lateral sides 100*pt* and 100*qt* of the plurality of GaN parent-crystal pieces 100*p* and 100*q* was 5 nm. The diameter of a circle inscribed on the outer periphery of, as whole, the plurality of GaN parent-crystal pieces 100*p* and 100*q* arranged in this way was 50.8 mm.

Next, referring to Fig. 6(C), the {20 2̅ 1} principal faces 100*pm* and 100*q*m of the plurality of GaN parent-crystal pieces 100*p* and 100*q* arranged inside the crystal-growth chamber of the HVPE apparatus were treated two hours at 800°C under a mixed-gas atmosphere of 10 vol. % gaseous hydrogen chloride (HCl) and 90 vol. % gaseous nitrogen (N₂), after which GaN crystal 110 was grown 50 hours by an HVPE technique onto the principal faces 100*pm* and 100*qm* under conditions in which the partial pressure of the hydrogen chloride gas that reacts with the Ga melt to generate the Ga chloride gas that is the Ga source-material gas was 2.2 kPa, the partial pressure of the ammonia (NH₃) gas that is the nitrogen source-material gas was 15.6 kPa, and the crystal-growth temperature was 1080°C.

The thickness of the obtained GaN crystal 110 was measured by a contact thickness gauge (a "Digimatic Indicator," Mitutoyo Corp. mfr.), whereupon it was 4 mm. That meant that the crystal growth rate was 80 µm/hr. Referring to Fig. 6(C), Fig. 2 and Fig. 3: By cutting eight GaN substrates out of this GaN crystal 110 in planes 110*u* and 110*v* parallel to a {20 2̅ 1} plane, and carrying out grinding and polishing processes on their two principal faces, eight GaN substrates were obtained, of 50.8 mm diameter × 400 µm thickness, whose first principal-face 1*m* average roughness *Ra* was 3 nm and whose second principal-face 1*n* average roughness *Ra* was 8 µm, and whose off-inclination angle toward a <1 2̅ 10> direction (the x-axis direction in Fig. 3) and whose off-inclination angle toward a direction (the *y*-axis direction in Fig. 3) perpendicular to a <20 2̅ 1> direction and a <1 2̅ 10> direction-being the off-inclination angles between the first principal face and a {20 2̅ 1} plane in each of points, along the first principal face 1*m*, Point *P_{c},* Point *P₁*, Point *P₂,* Point *P₃* and Point *P₄*-are each entered in Table I.

Herein, referring to Fig. 3, Point *P_{c},* is a point in the middle of the GaN substrate 1 on its first principal face 1*m*, while Point *P₁*, Point *P₂,* Point *P₃* and Point *P₄* are each a point on the first principal face and separated 3 mm from the outer edge thereof, with Point *P₁*, Point *P_{c}* and Point *P₂* lying in that order on a straight line in a <1 2̅ 10> direction and Point *P₃,* Point *P_{c}* and Point *P₄* lying in that order on a straight line in a direction perpendicular to a <20 2̅ 1> direction and a <1 2̅ 10> direction.

### 2. Storing of GaN Substrates

Each of seven GaN substrates within the eight GaN substrates obtained as above-described was washed and then stored for six months within an atmosphere having the oxygen concentrations and water-vapor concentrations set forth in Table I-within atmospheres being a gaseous mixture of gaseous nitrogen as an inert gas, gaseous oxygen, and water vapor (Ex. 1-1 through Ex. 1-6 and Ex. I-R1). The remaining single GaN substrate, without undergoing storage of this sort, after the aforementioned production and washing of the GaN substrate was within 10 minutes placed inside the crystal-growth reaction chamber of an MOCVD apparatus, and semiconductor devices were fabricated as in the following (Ex. I-S).

### 3. Fabrication of Semiconductor Devices

Referring to Fig. 4 and Fig. 5: The foregoing seven GaN substrates following storage (Ex. 1-1 through Ex. 1-6 and Ex. I-R1) and the non-stored single GaN substrate (Ex. I-S) were each placed inside the crystal-growth reaction chamber of an MOCVD apparatus, and a 5-*µ*m thick *n*-type GaN lamina 211, a 3-nm thick In_{0.2}Ga_{0.8}N lamina 212, a 60-nm thick Al_{0.2}Ga_{0.8}N lamina 213, and a 150-nm thick *p*-type GaN lamina 214 were grown in order, as the semiconductor layer 210, onto the first principal face 1*m* of each GaN substrate 1 to yield a semiconductor wafer 200*u*. Herein, Point *Q_{c},* Point *Q₁,* Point *Q₂,* Point *Q₃* and Point *Q₄* on the principal face of the semiconductor layer 210 in the semiconductor wafer 200*u* are each positioned on a line normal to its first principal face through the Point *P_{c},* Point *P₁,* Point *P₂,* Point *P₃* and Point *P₄* on the first principal face 1*m* of the GaN substrate 1.

As indicated in Fig. 4, in four neighbor regions of Point *Q₁,* Point *Q₂,* Point *Q₃* and Point *Q₄* of 5 mm width, separated 3 mm to 10 mm from the outer edge of the principal face of the semiconductor wafer 200*u*, a 100-nm thick *p*-side electrode 222 was formed onto the principal face of the *p*-type GaN lamina 214, and then an 80-µm diameter × 100-nm thick *n*-side electrode 221 was formed onto the second principal face of the GaN substrate, to yield, as semiconductor devices 200, ten in each neighbor region for a total 40 LEDs of 500 µm × 500 µm geometry. The photoemission intensity of the 40 LEDs obtained in this way was measured by means of a spectral photometer, and their average photoemission intensities were computed. The relative average photoemission intensities of Ex. I-S, Ex. 1-1 through Ex. 1-6 and Ex. I-R1, letting the average photoemission intensity of semiconductor device Ex. I-S be 1.00, were tabulated in Table I.

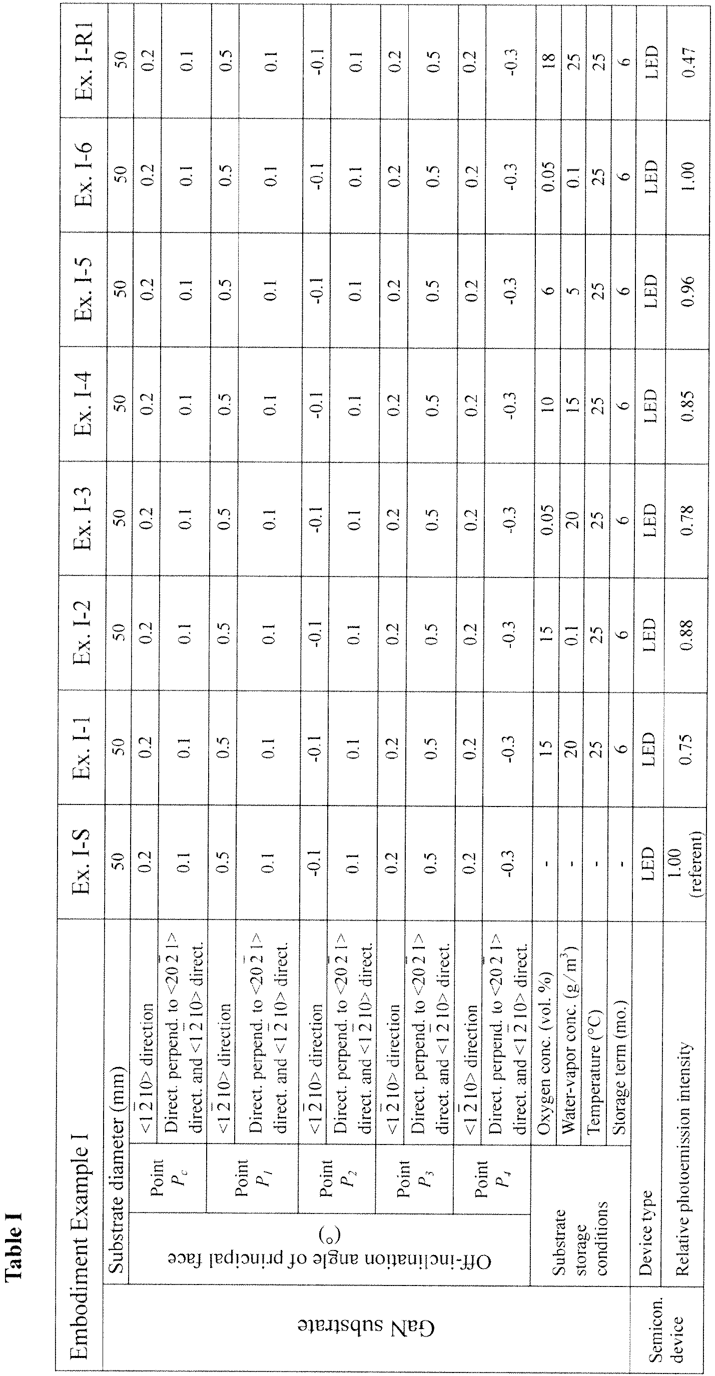

Referring to Table I, with regard to semiconductor devices in which an at least single-lamina semiconductor layer was formed onto the first principal face of a GaN substrate whose plane orientation in an arbitrary point (e.g., Point *P₁*, Point *P₂,* Point *P₃* or Point *P₄*) along the first principal face and separated 3 mm or more from the outer edge thereof had an off-inclination angle of -0.5° or more, 0.5° or less in a <1 2̅ 10> direction with respect to {20 2̅ 1} and -0.5° or more, 0.5° or less in a direction perpendicular to a <20 2̅ 1> direction and a <1 2̅ 10> direction, the following was understood. The relative average photoemission intensity of semiconductor devices (Ex. I-1 through Ex. 1-6) utilizing GaN substrates stored within an atmosphere ranging from an oxygen concentration of 0.05 vol. % and water-vapor concentration of 0.1 g/m³ to an oxygen concentration of 15 vol. % and water-vapor concentration of 20 g/m³ was sustained at a high 0.75 to 1.00 with respect to the relative average photoemission intensity of the semiconductor device (Ex. I-S) employing the post-formation not-stored GaN substrate.

### Embodiment Example II

### 1. Manufacture of GaN Substrates

In the same way as with Embodiment Example I, a plurality of GaN parent-crystal pieces was cut from a GaN parent crystal. With any of the cut-out GaN parent-crystal pieces, the off-inclination angle of its principal-face plane orientation with respect to {20 2̅ 1} was -2° or more, 2° or less. Next, the plurality of GaN parent crystals was arranged in the same way as with Embodiment Example I, and GaN crystal was grown by an HVPE technique onto their principal face. The GaN crystal was grown 40 hours under conditions in which the partial pressure of the hydrogen chloride gas that reacts with the Ga melt to generate the Ga chloride gas that is the Ga source-material gas was 3.3 kPa, the partial pressure of the ammonia (NH₃) gas that is the nitrogen source-material gas was 15.6 kPa, and the crystal-growth temperature was 1080°C. The obtained GaN crystal had 5 mm thickness. That meant that the crystal growth rate was 125 µm/hr. Next, in the same way as with Embodiment Example I, by cutting eight GaN substrates out of the GaN crystal and grinding and polishing their two principal faces, eight GaN substrates were obtained, of 50.8 mm diameter × 400 µm thickness, whose first principal-face average roughness *Ra* was 4.3 nm and whose second principal-face average roughness *Ra* was 9.3 µm, and whose off-inclination angle toward a <1 2̅ 10> direction and whose off-inclination angle toward a direction perpendicular to a <20 2̅ 1> direction and a <1 2̅ 10> direction-being the off-inclination angles between the first principal face and a {20 2̅ 1} plane in each of points, along the first principal face, Point *P_{c},* Point *P₁*, Point *P₂*, Point *P₃* and Point *P₄*-are each entered in Table II.

### 2. Storing of GaN Substrates

Each of seven GaN substrates within the eight GaN substrates obtained as above-described was washed and then stored for six months within an atmosphere having the oxygen concentrations and water-vapor concentrations set forth in Table II-within atmospheres being a gaseous mixture of gaseous nitrogen as an inert gas, gaseous oxygen, and water vapor (Ex. II-1 through Ex. II-6 and Ex. II-R1). The remaining single GaN substrate, without undergoing storage of this sort, after the aforementioned production and washing of the GaN substrate was within 10 minutes placed inside the crystal-growth reaction chamber of an MOCVD apparatus, and semiconductor devices were fabricated as in the following (Ex. II-S).

### 3. Fabrication of Semiconductor Devices

On each of the foregoing seven GaN substrates following storage (Ex. II-1 through Ex. II-6 and Ex. II-R1) and the non-stored single GaN substrate (Ex. II-S), in the same way as with Embodiment Example I, 40 LEDs, being semiconductor devices, were fabricated. The relative average photoemission intensities of Ex. II-1 through Ex. II-6 and Ex. II-R1, letting the average photoemission intensity of semiconductor device Ex. II-S be 1.00, were tabulated in Table II.

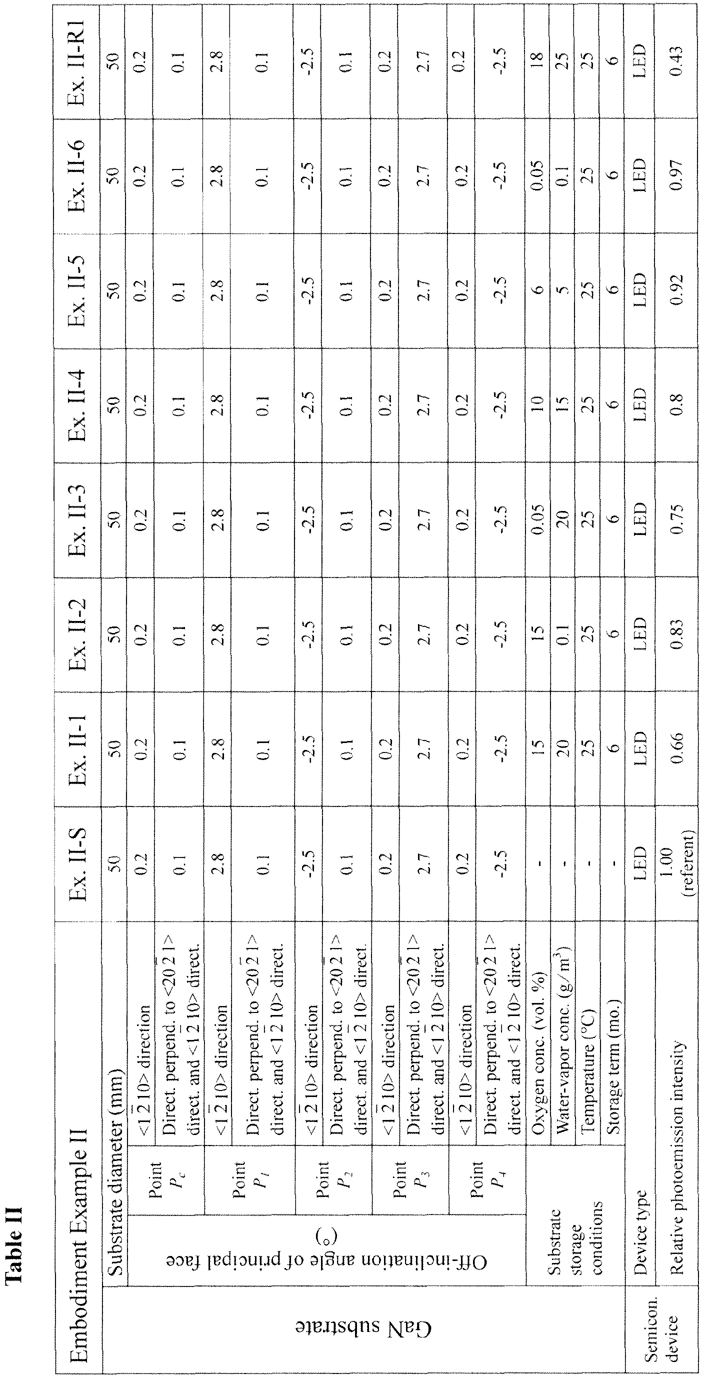

Referring to Table II, with regard to semiconductor devices in which an at least single-lamina semiconductor layer was formed onto the first principal face of a GaN substrate whose plane orientation in an arbitrary point (e.g., Point *P₁*, Point *P₂,* Point *P₃* or Point *P₄*) along the first principal face and separated 3 mm or more from the outer edge thereof had an off-inclination angle of -3.0° or more, 3.0° or less in a <1 2̅ 10> direction with respect to {20 2̅ 1} and -3.0° or more, 3.0° or less in a direction perpendicular to a <20 2̅ 1> direction and a <1 2̅ 10> direction, the following was understood. The relative average photoemission intensity of semiconductor devices (Ex. II-1 through Ex. II-6) utilizing GaN substrates stored within an atmosphere ranging from an oxygen concentration of 0.05 vol. % and water-vapor concentration of 0.1 g/m³ to an oxygen concentration of 15 vol. % and water-vapor concentration of 20 g/m³ was sustained at a high 0.66 to 0.97 with respect to the relative average photoemission intensity of the semiconductor device (Ex. II-S) employing the post-formation not-stored GaN substrate.

### Embodiment Example III

### 1. Manufacture of GaN Substrates

In the same way as with Embodiment Example I, a plurality of GaN parent-crystal pieces was cut from a GaN parent crystal. With any of the cut-out GaN parent-crystal pieces, the off-inclination angle of its principal-face plane orientation with respect to {202 1} was -5° or more, 5° or less. Next, the plurality of GaN parent crystals was arranged in the same way as with Embodiment Example I, and GaN crystal was grown by an HVPE technique onto their principal face. The GaN crystal was grown 40 hours under conditions in which the partial pressure of the hydrogen chloride gas that reacts with the Ga melt to generate the Ga chloride gas that is the Ga source-material gas was 4.3 kPa, the partial pressure of the ammonia (NH₃) gas that is the nitrogen source-material gas was 15.6 kPa, and the crystal-growth temperature was 1080°C. The obtained GaN crystal had 6 mm thickness. That meant that the crystal growth rate was 150 µm/hr. Next, in the same way as with Embodiment Example I, by cutting eight GaN substrates out of the GaN crystal and grinding and polishing their two principal faces, eight GaN substrates were obtained, of 50.8 mm diameter × 400 µm thickness, whose first principal-face average roughness *Ra* was 2.3 nm and whose second principal-face average roughness *Ra* was 3.1 µm, and whose off-inclination angle toward a <1 2̅ 10> direction and whose off-inclination angle toward a direction perpendicular to a <20 2̅ 1> direction and a <1 2̅ 10> direction-being the off-inclination angles between the first principal face and a {20 2̅ 1} plane in each of points, along the first principal face, Point *P_{c},* Point *P₁*, Point *P₂,* Point *P₃* and Point *P₄-are* each entered in Table III.

### 2. Storing of GaN Substrates

Each of seven GaN substrates within the eight GaN substrates obtained as above-described was washed and then stored for six months within an atmosphere having the oxygen concentrations and water-vapor concentrations set forth in Table III-within atmospheres being a gaseous mixture of gaseous nitrogen as an inert gas, gaseous oxygen, and water vapor (Ex. III-1 through Ex. III-6 and Ex. III-R1). The remaining single GaN substrate, without undergoing storage of this sort, after the aforementioned production and washing of the GaN substrate was within 10 minutes placed inside the crystal-growth reaction chamber of an MOCVD apparatus, and semiconductor devices were fabricated as in the following (Ex. III-S).

### 3. Fabrication of Semiconductor Devices

On each of the foregoing seven GaN substrates following storage (Ex. III-1 through Ex. III-6 and Ex. III-R1) and the non-stored single GaN substrate (Ex. III-S), in the same way as with Embodiment Example I, 40 LEDs, being semiconductor devices, were fabricated. The relative average photoemission intensities of Ex. III-1 through Ex. III-6 and Ex. III-R1, letting the average photoemission intensity of semiconductor device Ex. III-S be 1.00, were tabulated in Table III.

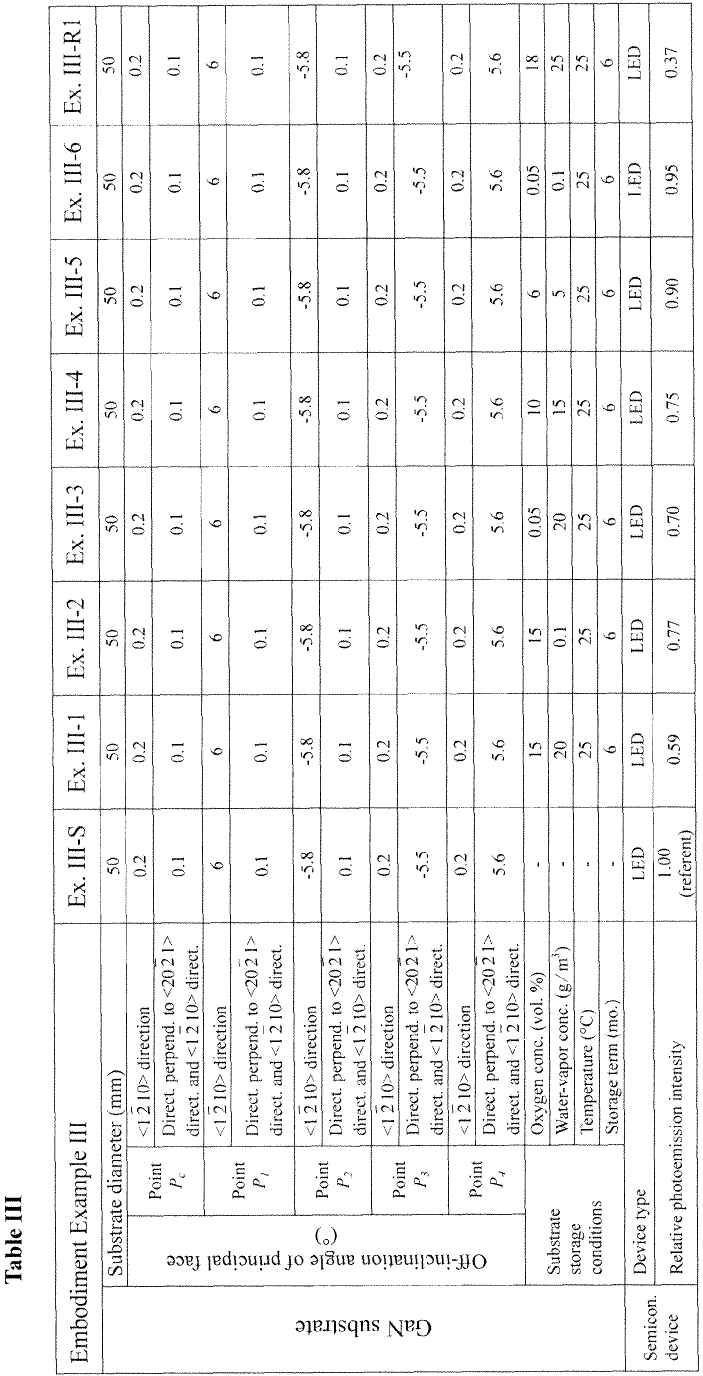

Referring to Table III, with regard to semiconductor devices in which an at least single-lamina semiconductor layer was formed onto the first principal face of a GaN substrate whose plane orientation in an arbitrary point (e.g., Point *P₁*, Point *P₂,* Point *P₃* or Point *P₄*) along the first principal face and separated 3 mm or more from the outer edge thereof had an off-inclination angle of -6.0° or more, 6.0° or less in a <1 2̅ 10> direction with respect to {20 2̅ 1} and -6.0° or more, 6.0° or less in a direction perpendicular to a <20 2̅ 1> direction and a <1 2̅ 10> direction, the following was understood. The relative average photoemission intensity of semiconductor devices (Ex. III-1 through Ex. III-6) utilizing GaN substrates stored within an atmosphere ranging from an oxygen concentration of 0.05 vol. % and water-vapor concentration of 0.1 g/m³ to an oxygen concentration of 15 vol. % and water-vapor concentration of 20 g/m³ was sustained at a high 0.59 to 0.95 with respect to the relative average photoemission intensity of the semiconductor device (Ex. III-S) employing the post-formation not-stored GaN substrate.

### Embodiment Example IV

### 1. Manufacture of GaN Substrates

In the same way as with Embodiment Example I, a plurality of GaN parent-crystal pieces was cut from a GaN parent crystal. With any of the cut-out GaN parent-crystal pieces, the off-inclination angle of its principal-face plane orientation with respect to {20 2̅ 1} was -9° or more, 9° or less. Next, the plurality of GaN parent crystals was arranged in the same way as with Embodiment Example I, and GaN crystal was grown by an HVPE technique onto their principal face. The GaN crystal was grown 40 hours under conditions in which the partial pressure of the hydrogen chloride gas that reacts with the Ga melt to generate the Ga chloride gas that is the Ga source-material gas was 6.4 kPa, the partial pressure of the ammonia (NH₃) gas that is the nitrogen source-material gas was 15.6 kPa, and the crystal-growth temperature was 1080°C. The obtained GaN crystal had 8 mm thickness. That meant that the crystal growth rate was 200 µm/hr. Next, in the same way as with Embodiment Example I, by cutting eight GaN substrates out of the GaN crystal and grinding and polishing their two principal faces, eight GaN substrates were obtained, of 50.8 mm diameter × 400 µm thickness, whose first principal-face average roughness *Ra* was 0.6 nm and whose second principal-face average roughness *Ra* was 0.8 µm, and whose off-inclination angle toward a <1 2̅ 10> direction and whose off-inclination angle toward a direction perpendicular to a <20 2̅ 1> direction and a <1 2̅ 10> direction-being the off-inclination angles between the first principal face and a {20 2̅ 1} plane in each of points, along the first principal face, Point *P_{c},* Point *P₁*, Point *P₂,* Point *P₃* and Point *P₄*-are each entered in Table IV.

### 2. Storing of GaN Substrates

Each of seven GaN substrates within the eight GaN substrates obtained as above-described was washed and then stored for six months within an atmosphere having the oxygen concentrations and water-vapor concentrations set forth in Table IV-within atmospheres being a gaseous mixture of gaseous nitrogen as an inert gas, gaseous oxygen, and water vapor (Ex. IV-1 through Ex. IV-6 and Ex. IV-R1). The remaining single GaN substrate, without undergoing storage of this sort, after the aforementioned production and washing of the GaN substrate was within 10 minutes placed inside the crystal-growth reaction chamber of an MOCVD apparatus, and semiconductor devices were fabricated as in the following (Ex. IV-S).

### 3. Fabrication of Semiconductor Devices

On each of the foregoing seven GaN substrates following storage (Ex. IV-1 through Ex. IV-6 and Ex. IV-R1) and the non-stored single GaN substrate (Ex. IV-S), in the same way as with Embodiment Example I, 40 LEDs, being semiconductor devices, were fabricated. The relative average photoemission intensities of Ex. IV-1 through Ex. IV-6 and Ex. IV-R1, letting the average photoemission intensity of semiconductor device Ex. IV-S be 1.00, were tabulated in Table IV.

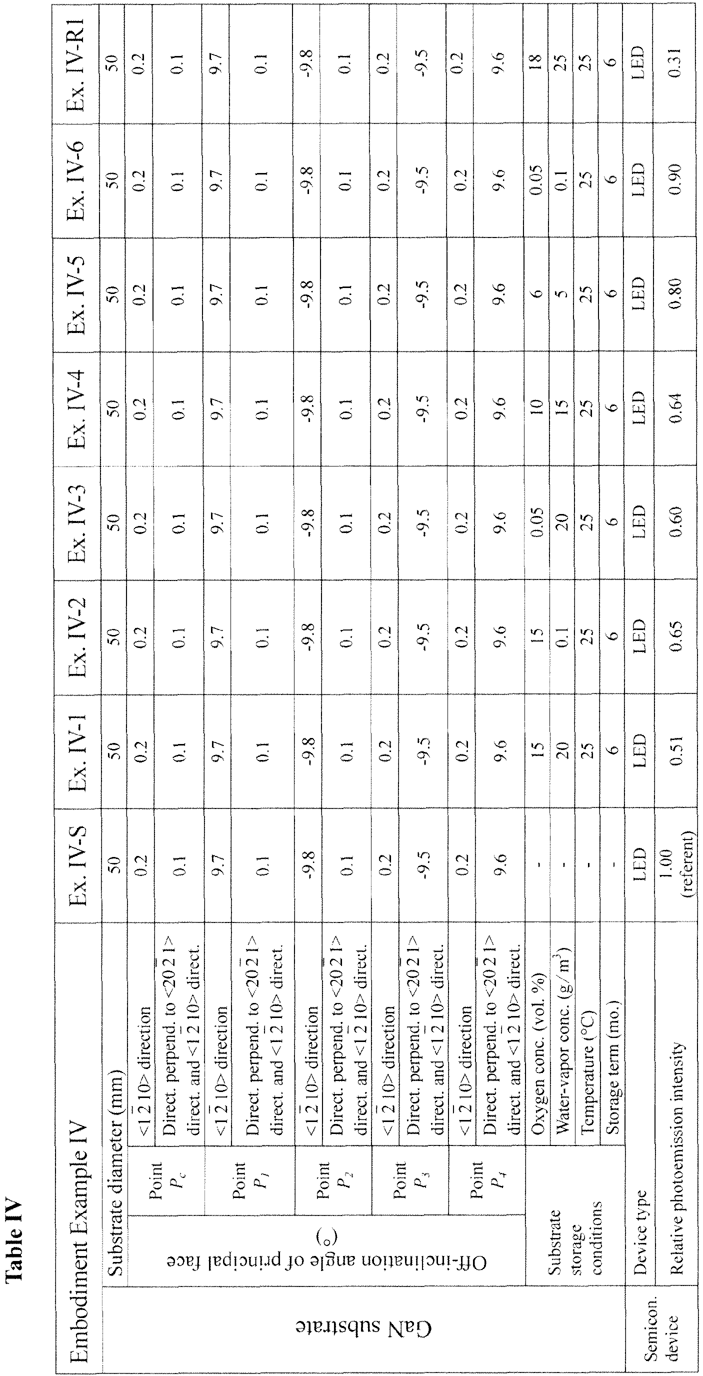

Referring to Table IV, with regard to semiconductor devices in which an at least single-lamina semiconductor layer was formed onto the first principal face of a GaN substrate whose plane orientation in an arbitrary point (e.g., Point *P₁*, Point *P₂,* Point *P₃* or Point *P₄*) along the first principal face and separated 3 mm or more from the outer edge thereof had an off-inclination angle of -10.0° or more, 10.0° or less in a <1 2̅ 10> direction with respect to {20 2̅ 1} and -10.0° or more, 10.0° or less in a direction perpendicular to a <20 2̅ 1> direction and a <1 2̅ 10> direction, the following was understood. The relative average photoemission intensity of semiconductor devices (Ex. IV-1 through Ex. IV-6) utilizing GaN substrates stored within an atmosphere ranging from an oxygen concentration of 0.05 vol. % and water-vapor concentration of 0.1 g/m³ to an oxygen concentration of 15 vol. % and water-vapor concentration of 20 g/m³ was sustained at a high 0.51 to 0.90 with respect to the relative average photoemission intensity of the semiconductor device (Ex. IV-S) employing the post-formation not-stored GaN substrate.

It should be noted that although in the foregoing Embodiment Example I through Embodiment Example IV the storing term is in each case 6 months, it has been verified that the effects obtained do not change if the storing term is under 6 months or exceeds 6 months.

### Reference Signs List

**1:** GaN substrate; **1*a***: crystalline plane; **1*c***: plane being either the (0001) plane or the (0001) plane; ***1m,* 1*****n**,* ***100pm,* 100*qm*, 110*pm*:** principal faces; **10:** storing device; **20:** gas introduction line; **23, 43:** gases; **29:** gas introduction valve; **31:** oxygen scavenger; **32:** dehydrating agent; **40:** gas exhaust line; **49:** gas exhaust valve; **100:** GaN parent crystal; **100*p*, 100*q*:** GaN parent-crystal pieces; ***100pt,* 100*qt*:** lateral sides; **110, 120:** GaN crystal; **110*p*, 110*q*, 120*p*, 120*q*:** sectional regions; **110*s*:** GaN starting substrate; **110*t*, 120*t*:** extension planes; **110*u*, 110*v***, **120*u*, 120*v*:** parallel planes; **200:** semiconductor device; **200*u*:** semiconductor wafer; **210:** semiconductor layer; **211:** *n*-type GaN lamina; **212:** In_{0.2}Ga_{0.8}N lamina; **213:** Al_{0.2}Ga_{0.8}N lamina; **214:** *p*-type GaN lamina; **221:** *n*-side electrode; **222:** *p*-side electrode; **230:** photoemission

## Claims

1. A single crystal GaN substrate storage method of storing, within an atmosphere in which the oxygen concentration is not greater than 15 vol. % and the water-vapor concentration is not greater than 20 g/m³, a single crystal GaN substrate (1) having a first principal face (1*m*), and whose plane orientation in an arbitrary point (P1,P2,P3,P4,PC) on the surface of the GaN substrate along the first principal face (1*m*) and separated 3 mm or more from the outer edge thereof has an off-inclination angle *Δα* of -3° ≤ *Δα* ≤ 3° in a <12̅10> direction with respect to {202̅1} at the arbitrary point, and of -3° ≤ *Δα* ≤ 3° in a direction perpendicular to a <202̅1> direction and to a <12̅10> direction with respect to {202̅1} at the arbitrary point.

2. The single crystal GaN substrate storage method set forth in claim 1, wherein the oxygen concentration is not greater than 10 vol. % and the water-vapor concentration not greater than 15 g/m³.

3. The single crystal GaN substrate storage method set forth in claim 1, wherein the oxygen concentration is not greater than 6 vol. % and the water-vapor concentration is not greater than 5 g/m³.

4. The single crystal GaN substrate storage method set forth in claim 1, wherein the atmosphere under which the single crystal GaN substrate is stored is formed from a gaseous mixture containing an inert gas, gaseous oxygen, and water vapor, with the oxygen concentration being not less than 0.05 vol. % and the water-vapor concentration being not less than 0.1 g/m³.

5. The single crystal GaN substrate storage method set forth in claim 1, wherein the average roughness *Ra* of the first principal face (1*m*) is 20 nm or less, and the average roughness *Ra* of the second principal face (1*n*) is 20 µm or less.

6. The single crystal GaN substrate storage method set forth in claim 1, wherein the average roughness *Ra* of the first principal face (1*m*) is 5 nm or less, and the average roughness *Ra* of the second principal face (1*n*) is 10 µm or less.

7. The single crystal GaN substrate storage method set forth in claim 1, wherein the plane orientation in an arbitrary point (P1 ,P2,P3,P4,PC) on the surface of the GaN substrate along the first principal face (1*m*) and separated 3 mm or more from the outer edge thereof has an off-inclination angle *Δα* of -0.5° ≤ *Δα* ≤ 0.5° in a <12̅10> direction with respect to {202̅1} at the arbitrary point, and of -0.5° ≤ *Δα* ≤ 0.5° in a direction perpendicular to a <202̅1> direction and to a <12̅10> direction with respect to {202̅1} at the arbitrary point.

## Patentansprüche

1. Verfahren zum Aufbewahren eines einkristallinen GaN-Substrats, um in einer Atmosphäre, in der die Sauerstoffkonzentration nicht größer als 15 Vol.% und die Wasserdampfkonzentration nicht größer als 20 g/m³ ist, ein einkristallines GaN-Substrat (1) aufzubewahren, das eine erste Hauptfläche (1m) aufweist und dessen Ebenenorientierung an einem beliebigen Punkt (P1, P2, P3, P4), PC) auf der Oberfläche des GaN-Substrats entlang der ersten Hauptfläche (1m) und 3 mm oder mehr von dessen Außenkante getrennt einen Neigungswinkel Δα von -3° ≤ Δα ≤ 3° in einer <1-210> Richtung in Bezug auf {20-21} am beliebigen Punkt und von -3° ≤ Δα ≤ 3° in einer Richtung senkrecht zu einer <20-21> Richtung und zu einer <1-210> Richtung in Bezug auf {20-21} am beliebigen Punkt aufweist.

2. Verfahren zum Aufbewahren des einkristallinen GaN-Substrats nach Anspruch 1, wobei die Sauerstoffkonzentration nicht größer als 10 Vol.% und die Wasserdampfkonzentration nicht größer als 15 g/m³ ist.

3. Verfahren zum Aufbewahren des einkristallinen GaN-Substrats nach Anspruch 1, wobei die Sauerstoffkonzentration nicht größer als 6 Vol.% und die Wasserdampfkonzentration nicht größer als 5 g/m³ ist.

4. Verfahren zum Aufbewahren des einkristallinen GaN-Substrats nach Anspruch 1, wobei die Atmosphäre, in der das einkristalline GaN-Substrat aufbewahrt wird, aus einer Gasmischung gebildet wird, die ein Inertgas, gasförmigen Sauerstoff und Wasserdampf enthält, wobei die Sauerstoffkonzentration nicht weniger als 0,05 Vol.% und die Wasserdampfkonzentration nicht weniger als 0,1 g/m³ beträgt.

5. Verfahren zum Aufbewahren des einkristallinen GaN-Substrats nach Anspruch 1, wobei der Mittenrauwert Ra der ersten Hauptfläche (1m) 20 nm oder weniger und der Mittenrauwert Ra der zweiten Hauptfläche (1n) 20 µm oder weniger beträgt.

6. Verfahren zum Aufbewahren des einkristallinen GaN-Substrats nach Anspruch 1, wobei der Mittenrauwert Ra der ersten Hauptfläche (1m) 5 nm oder weniger und der Mittenrauwert Ra der zweiten Hauptfläche (1n) 10 µm oder weniger beträgt.

7. Verfahren zum Aufbewahren des einkristallinen GaN-Substrats nach Anspruch 1, wobei die Ebenenorientierung an einem beliebigen Punkt (P1, P2, P3, P4, PC) auf der Oberfläche des GaN-Substrats entlang der ersten Hauptfläche (1m) und 3 mm oder mehr von dessen Außenkante getrennt einen Neigungswinkel Δα von -0,5° ≤ Δα ≤ 0,5° in einer <1-210> Richtung in Bezug auf {20-21} am beliebigen Punkt und von -0,5° ≤ Δα ≤ 0,5° in einer Richtung senkrecht zu einer <20-21> Richtung und zu einer <1-210> Richtung in Bezug auf {20-21} am beliebigen Punkt aufweist.

## Revendications

1. Procédé de stockage de conservation d'un substrat en GaN monocristallin, au sein d'une atmosphère dans laquelle la concentration en oxygène n'est pas supérieure à 15 % en volume et la concentration de vapeur d'eau n'est pas supérieure à 20 g/m³, un substrat en GaN monocristallin (1) ayant une première face principale (1*m*), et dont l'orientation des plans au niveau d'un point arbitraire (P1, P2, P3, P4, PC) sur la surface du substrat en GaN le long de la première face principale (1*m*) et distant de 3 mm ou plus du bord extérieur de celle-ci présente un angle d'écartement d'inclinaison *Δα* de -3° ≤ *Δα* ≤ 3° dans une direction <12̅10> par rapport à {202̅1} au niveau du point arbitraire, et de -3° ≤ *Δα* ≤ 3° dans une direction perpendiculaire à une direction <202̅1> et à une direction <12̅10> par rapport à {202̅1} au niveau du point arbitraire.

2. Procédé de stockage de substrat en GaN monocristallin selon la revendication 1, dans lequel la concentration en oxygène n'est pas supérieure à 10 % en volume et la concentration de vapeur d'eau n'est pas supérieure à 15 g/m³.

3. Procédé de stockage de substrat en GaN monocristallin selon la revendication 1, dans lequel la concentration en oxygène n'est pas supérieure à 6 % en volume et la concentration de vapeur d'eau n'est pas supérieure à 5 g/m³.

4. Procédé de stockage de substrat en GaN monocristallin selon la revendication 1, dans lequel l'atmosphère dans laquelle le substrat en GaN monocristallin est stocké est formée d'un mélange gazeux contenant un gaz inerte, de l'oxygène gazeux et de la vapeur d'eau, la concentration en oxygène n'étant pas inférieure à 0,05 % en volume et la concentration de vapeur d'eau n'étant pas inférieure à 0,1 g/m³.

5. Procédé de stockage de substrat en GaN monocristallin selon la revendication 1, dans lequel la rugosité moyenne *Ra* de la première face principale (1*m*) est inférieure ou égale à 20 nm, et la rugosité moyenne *Ra* de la seconde face principale (1*n*) est inférieure ou égale à 20 µm.

6. Procédé de stockage de substrat en GaN monocristallin selon la revendication 1, dans lequel la rugosité moyenne *Ra* de la première face principale (1*m*) est inférieure ou égale à 5 nm, et la rugosité moyenne *Ra* de la seconde face principale (1*n*) est inférieure ou égale à 10 µm.

7. Procédé de stockage de substrat en GaN monocristallin selon la revendication 1, dans lequel l'orientation des plans au niveau d'un point arbitraire (P1, P2, P3, P4, PC) sur la surface du substrat en GaN le long de la première face principale (1*m*) et distant de 3 mm ou plus du bord extérieur de celle-ci présente un angle d'écartement d'inclinaison *Δα* de -0,5° ≤ *Δα* ≤ 0,5° dans une direction <12̅10> par rapport à {202̅1} au niveau du point arbitraire, et de -0,5° ≤ *Δα* ≤ 0,5° dans une direction perpendiculaire à une direction <202̅1> et à une direction <12̅10> par rapport à {202̅1} au niveau du point arbitraire.
